# EUROPÄISCHE PATENTANMELDUNG

(11) **EP 4 553 544 A1**
(43) Veröffentlichungstag der Anmeldung: **14.05.2025**
(21) Anmeldenummer: 24218338.2
(22) Anmeldetag: 07.03.2016
(51) Int. Cl.: G01T 1/00

(54) **FOLIE AUS METALL ODER EINER METALLLEGIERUNG**

(30) Priorität: 06.03.2015 DE 102015002789; 17.11.2015 DE 102015014721
(62) Teilanmeldung aus: 24211764.6
(71) Anmelder: Neutrino Deutschland GmbH, 76532 Baden-Baden (DE)
(72) Erfinder: SCHUBART, Holger Thorsten, 10117 Berlin (DE)
(74) Vertreter: FARAGO Patentanwälte GmbH

(57) **Zusammenfassung**

Die Erfindung betrifft eine Folie aus Metall oder einer Metalllegierung insbesondere eine Folie aus Aluminium oder einer Aluminiumlegierung eine sogenannte Neutrino- oder Ntrino-Folie (registrierte Marken), ein Verfahren zur Herstellung sowie eine Verwendung einer Folie aus Metall oder einer Metalllegierung,

## Beschreibung

Die Erfindung betrifft eine Folie aus Metall oder einer Metalllegierung insbesondere eine Folie aus Aluminium oder einer Aluminiumlegierung eine sogenannte Neutrino- oder Ntrino-Folie (registrierte Marken), ein Verfahren zur Herstellung sowie eine Verwendung einer Folie aus Metall oder einer Metalllegierung.

Metallfolien insbesondere Aluminiumfolien sind aus dem Stand der Technik zahlreich bekannt.

Aufgabe der vorliegenden Erfindung ist es, Metallfolien insbesondere Aluminiumfolien weiter zu verbessern. Diese können dann dazu dienen, nicht sichtbare Solarenergie in Gleichstrom zu wandeln, dies erfolgt insbesondere indem Neutrino-Strahlung in Energie gewandelt wird.

Diese Aufgabe wird nach einem ersten Aspekt der Erfindung durch eine Folie aus Metall oder einer Metalllegierung gelöst, wobei die Folie eine Beschichtung aufweist, die Graphen und Silizium aufweist. Auf den metallischen Träger werden in unterschiedlichen Verfahren (aufgedampft, besprüht, aufgeklebt) weitere Materialien in unterschiedlicher Abfolge aufgetragen. Der Effekt der damit erzielt wird besteht darin, dass Bewegungsenergie von Strahlungen (das nichtsichtbare Spektrum der Sonnen- bzw. Raumstrahlung wie z.B. Neutrinos) in Strom gewandelt wird. Dies erfolgt durch eine nanotechnologisch veränderte Gitterstruktur der aufgetragenen Materialien. Die veränderte und verdichtete Gitterstruktur dient als Bremsmedium (beispielsweise dotiertes Graphen) welches die Welle um ca. 0.1 ‰ verlangsamt, indem Molekühle des nicht sichtbaren Spektrums der Sonnen- bzw. Raumenergie Molekühle der verdichteten, so nicht in der Natur vorkommenden Gitterstruktur anstoßen. Jene Pendelbewegung wird im nächsten Schritt auf ein Leitermedium übertragen (z.B. Silizium) und dann auf das Überträgermedium (z.B. Aluminium, Silber, Gallium usw.).

Bei dem metallischen Träger bzw. der Metalllegierung kann es sich um eine gängige Legierung handeln. Vorteilhafterweise ist die Folie aus Silber, Gold, Kupfer, Gallium oder Aluminium oder einer ihrer Legierungen, insbesondere aus einer Silber- oder Goldlegierung oder einer Aluminium-Gallium-Legierung. Dabei hat eine Folie aus Aluminium oder einer Aluminiumlegierung Kostenvorteile. Eine Folie aus Silber oder einer Silberlegierung erzielen bessere Werte.

Bei einer Aluminiumlegierung kann es sich um eine gängige Aluminiummetalllegierung handeln. Beispielsweise eine Aluminium- Gold- oder - Silberlegierung ist möglich. Auch andere Legierungen, wie beispielsweise eine Aluminium-Mangan, -Magnesium-, -Kupfer-, -Silizium-, -Nickel-, -Zink-, Berylliumlegierung, sowie deren Mischungen sind möglich.

Besonders vorteilhaft ist, wenn die Folie aus einer Aluminium-Galliumlegierung oder aus Gold oder Silber, einer Gold oder Silberlegierung ist. Dies hat den Vorzug einer höheren Leitfähigkeit, indem die Flussgeschwindigkeit erhöht wird.

Weiter von Vorteil ist, wenn die Folie eine Dicke von 0,01 mm bis 4 mm, vorzugsweise von 0,01 mm bis 1 mm, besonders vorzugsweise 0,05 mm - 1 mm aufweist.

Weiter kann die Beschichtung ca. 10% bis 80% Silizium, vorzugsweise 10% bis 50% Silizium, besonders vorzugsweise 25% Silizium, aufweisen.

Ebenfalls kann die Beschichtung 20% bis 90% Graphen, vorzugsweise 50% bis 90% Graphen, besonders vorzugsweise 75% Graphen, aufweisen.

Weiter von Vorteil ist, wenn die Beschichtung organische oder anorganische Klebebestandteile aufweist. Auch andere gängige Verbindungsverfahren außer Kleben beispielsweise auch durch Auftragen sind vorteilhaft.

Die Beschichtung kann in einzelnen geschichteten Substanzen erfolgen oder anhand einer Mischung. Besonders vorteilhaft ist, wenn die nanotechnologisch aufbereiteten Substanzen einzeln geschichtete werden, da damit eine höhere Effizienz entsteht, das heißt mehr Strom produziert wird.

Besonders vorteilhaft ist, wenn die Beschichtung eine Nanobeschichtung ist, in der Graphen und Silizium als Nanopartikel vorliegen. Hierbei sollten die Partikel des Siliziums eine Größe von 5nm bis 500nm besonders vorzugsweise von 5nm und die des Graphen 20nm bis 500nm besonders vorzugsweise 20nm aufweisen, da der Wirkungsgrad erhöht wird, je kleiner die Partikel sind.

Vorteilhafterweise weist die Beschichtung wechselweise Schichten aus Silizium und Graphen auf, insbesondere 10 bis 20 Silizium- Graphen Schichten insbesondere 12 Silizium-Graphen Schichten aufweist. Dabei sind 12 Schichten besonders vorteilhaft, da nach 12 Lagen, die Spannung wieder abnimmt.

Weiter kann die Leistung der Folie gesteigert werden, wenn auf das Silizium Germanium, Selen, Kupferoxidal oder Tellur aufgetragen wird. Weitere Experimente, die die Leistung gesteigert haben, erfolgten mit Tantal, Niob, Molybdän und Antimon.

Wesentlich zur Steigerung der Leistung trägt die Dotierung des Graphens bei. Hierbei kann sowohl eine Dotierung im Vakuum durch Ionenimplantation erfolgen als auch einen Neutronen-Transmutationsdotierung. Dabei kann mit den Ionen folgender Partikel dotiert werden. Ferroniobium, Nickelniobium, Yttrium oder Samariumoxid. Mit Hilfe der Dotierung wird die Fläche des Graphens um den Faktor 10^6 vergrößert was unter Anderem zur Leistungssteigerung fährt.

Die Beschichtung sollte vorzugsweise unter Luftabschluss erfolgen, da je nach Dotierung der Oxidationseffekt schneller eintritt. Auch nach der erfolgten Beschichtung sollte die Folge versiegelt werden, da der Luftabschluss die Standfestigkeit erhöht.

Vorteilhafterweise werden 757g aller Materialien auf 1km^2 verwendet. Der metallische Träger stellt den Minuspol dar, das Graphen den Pluspol.

In der Anwendung können die Folie gerollt oder gestapelt werden, um die höchsten Werte zu erzielen. Eine DinA4 Folie kann 1 Watt, wenn man die Folien zu einem mobilen Kraftwerk stapelt, sollte eine Isolationssicht zwischen den Folien gelegt werden.

Die Stromerzeugung bewirkt keine Zersetzung des Leiters. Der Leiter hat einen negativen Temperaturkoeffizienten. Das Optimum liegt bei 26,2 bis 26,7 °C.

Die Folie kann unter der Erde und im Wasser verwendet werden und funktioniert besser bei Nacht als bei Tage.

Ein zweiter Aspekt der Erfindung betrifft ein Verfahren zum Herstellen einer Folie aus einem Metall oder einer Metalllegierung insbesondere einer erfindungsgemäßen Folie wobei in einem ersten Schritt eine Siliziumschicht auf die Folie aufgetragen wird, insbesondere durch Sprühen oder Dampfen, in einem zweiten Schritt die Siliziumschicht gehärtet, getrocknet und mit flüssigen Stickstoff gespült wird, in einem dritten Schritt eine Graphenschicht auf die Folie aufgetragen wird und in einem vierten Schritt die Graphenschicht gehärtet, getrocknet und mit flüssigem Stickstoff gespült wird.

Vorteilhafterweise kann in einem weiteren Schritt Germanium, Selen, Kupferoxidal, Tellur, Tantal, Niob, Molybdän und/oder Antimon aufgetragen werden.

In einem weiteren Schritt kann das Graphen dotiert werden, insbesondere mit Ferroniobium, Nickelniobium, Yttrium oder Samariumoxid insbesondere durch Ionenimplantation oder durch Neutronen-Transmutationsdotierung.

Ein dritter Aspekt der Erfindung betrifft ein Verfahren zum Herstellen einer Folie aus Aluminium oder einer Aluminiumlegierung, wobei in einem ersten Schritt Graphen und Silizium pulverisiert und vermischt werden und in einem zweiten Schritt das pulverisierte Graphen und Silizium auf die Folie aufgebracht werden.

Ein vierter Aspekt der Erfindung betrifft ein Verfahren zum Herstellen einer Folie aus Aluminium oder einer Aluminiumlegierung, insbesondere zum Herstellen einer erfindungsgemäßen Folie, wobei in einem ersten Schritt Graphen und Silizium pulverisiert und vermischt werden und in einem zweiten Schritt eine Klebeschicht auf die Folie aufgebracht wird und in einem dritten Schritt das pulverisierte Graphen und Silizium auf die Klebeschicht aufgebracht werden. Auch andere gängige Verbindungsverfahren außer Kleben beispielsweise auch durch Auftragen sind vorteilhaft.

Ein fünfter Aspekt der Erfindung betrifft ein Verfahren zum Herstellen einer Folie aus Aluminium oder einer Aluminiumlegierung, insbesondere zum Herstellen einer erfindungsgemäßen Folie, wobei in einem ersten Schritt Graphen und Silizium pulverisiert und vermischt werden und in einem zweiten Schritt ein Kleber mit Silizium- und Graphenpulver vermischt wird und in einem dritten Schritt die Mischung auf die Folie aufgebracht oder mit der Folie fest verbunden wird. Auch andere gängige Verbindungsverfahren außer Kleben beispielsweise auch durch Auftragen sind vorteilhaft.

Ein sechster Aspekt der Erfindung betrifft ein Verfahren zum Herstellen einer Folie aus Aluminium oder einer Aluminiumlegierung, insbesondere zum Herstellen einer erfindungsgemäßen Folie, wobei in einem ersten Schritt eine Klebeschicht auf die Folie aufgebracht wird und in einem zweiten Schritt eine Graphen- und/oder Siliziumschicht aufgebracht wird und in einem dritten Schritt eine zweite Klebeschicht auf die Folie aufgebracht wird und in einem vierten Schritt eine weitere Silizium- und/oder Graphenschicht auf die Folie aufgebracht wird. Auch andere gängige Verbindungsverfahren außer Kleben beispielsweise auch durch Auftragen sind vorteilhaft.

Ein siebter Aspekt der Erfindung betrifft eine Verwendung einer erfindungsgemäßen Folie zur Gewinnung von Gleichstrom aus nicht sichtbarer Sonnenenergie.

Die Funktionsweise kann zusammenfassend wie folgt beschrieben werden:
Die Natur hat relativ "weitmaschige" Moleküle, sodass die Neutrinos auf Grund der geringen Masse durchfliegen. Sowohl die Atome in den Molekülen als auch die Moleküle in der Stoff-Struktur müssen so eng "gepackt" werden, dass ein Teil der Neutrinos nicht ohne Berührung der Teilchen durchfliegen kann.

Die Folienoberfläche weist daher nanotechnologisch bearbeitet Strukturen auf, sodass analog einer mechanischen Pendelkette sich die Moleküle gegenseitig anstoßen und somit aus der Masse und der Bewegungsenergie ein Molekülfluss und Stromfluss entsteht (sog. Gitterführungseffekt).

Dies ist analog zu einem Stromfluss in einer Leitung zu verstehen: durch Magnet und Spule werden die Moleküle im Generator in Bewegung gesetzt und so können wir die Elektrizität nutzen.

Die Erfindung wird nachfolgend anhand eines Ausführungsbeispiels näher erläutert.

Graphen und Silizium werden in einem Mörser zerstoßen oder anderweitig pulverisiert (bis Nanogröße). Auf eine handelsübliche Aluminiumfolie wird eine organische Klebeschicht aufgetragen. Auf diese wird das Silizium- und Graphenpulver aufgebracht. So entsteht eine Folie aus Aluminium mit einer Beschichtung mit einer Dicke von 0,1 mm oder darunter. Das Verhältnis der Bestandteile Graphen und Silizium in der Beschichtung der Folie ist ca. 75% Graphen und 25% Silizium.

## Patentansprüche

1. Folie aus Metall oder einer Metalllegierung, **dadurch gekennzeichnet, dass** die Folie eine Beschichtung aufweist, die Graphen und Silizium aufweist.

2. Folie nach Anspruch 1, **dadurch gekennzeichnet, dass** die Folie aus Silber, Gold, Kupfer, Gallium oder Aluminium oder einer ihrer Legierungen, insbesondere aus einer Silber- oder Goldlegierung oder einer Aluminium-Gallium-Legierung ist.

3. Folie nach Anspruch 1 oder 2, **dadurch gekennzeichnet, dass** die Folie eine Dicke von 0,01 mm bis 4 mm, vorzugsweise von 0,01 mm bis 1 mm, aufweist.

4. Folie nach einem der Ansprüche 1 bis 3, **dadurch gekennzeichnet, dass** die Beschichtung 10% bis 80% Silizium, vorzugsweise 10% bis 50% Silizium, besonders vorzugsweise 25% Silizium, aufweist.

5. Folie nach einem der vorhergehenden Ansprüche, **dadurch gekennzeichnet, dass** die Beschichtung 20% bis 90% Graphen, vorzugsweise 50% bis 90% Graphen, besonders vorzugsweise 75% Graphen, aufweist.

6. Folie nach einem der vorhergehenden Ansprüche, **dadurch gekennzeichnet, dass** die Beschichtung organisch oder anorganische Klebebestandteile aufweist.

7. Folie nach einem der vorhergehenden Ansprüche, **dadurch gekennzeichnet, dass** die Beschichtung eine Nanobeschichtung ist, in der Graphen und Silizium als Nanopartikel vorliegen.

8. Folie nach Anspruch 7, **dadurch gekennzeichnet, dass** die Partikel des Siliziums eine Grösse vom 5 nm bis 500 nm insbesondere 5 nm aufweisen und die Partikel des Graphens eine Größe von 20 nm bis 500 nm insbesondere 20 nm aufweisen.

9. Folie nach einem der vorhergehenden Ansprüche, **dadurch gekennzeichnet, dass** die Beschichtung wechselweise Schichten auf wechselweise Silizium und Graphen aufweist, insbesondere 10 bis 20 Silizium-Graphen Schichten insbesondere 12 Silizium-Graphen Schichten.

10. Folie nach einem der vorhergehenden Ansprüche, **dadurch gekennzeichnet, dass** die Beschichtung Germanium, Selen, Kupferoxidal, Tellur, Tantal, Niob, Molybdän und/oder Antimon aufweist.

11. Folie nach einem der vorhergehenden Ansprüche, **dadurch gekennzeichnet, dass** das Graphen dotiert ist, insbesondere mit Ferroniobium, Nickelniobium, Yttrium oder Samariumoxid.

12. Verfahren zum Herstellen einer Folie aus einem Metall oder einer Metalllegierung, insbesondere nach einem der Ansprüche 1 bis 11, **dadurch gekennzeichnet, dass**
in einem ersten Schritt eine Siliziumschicht auf die Folie aufgetragen wird, insbesondere durch Sprühen oder Dampfen
in einem zweiten Schritt die Siliziumschicht gehärtet, getrocknet und mit flüssigen Stickstoff gespült wird,
in einem dritten Schritt eine Graphenschicht auf die Folie aufgetragen wird,
in einem vierten Schritt die Graphenschicht gehärtet, getrocknet und mit flüssigen Stickstoff gespült wird.

13. Verfahren zum Herstellen einer Folie aus Aluminium oder einer Aluminiumlegierung nach Anspruch 11, **dadurch gekennzeichnet, dass** in einem weiteren Schritt Germanium, Selen, Kupferoxidal, Tellur, Tantal, Niob, Molybdän und/oder Antimon aufgetragen wird.

14. Verfahren zum Herstellen einer Folie aus Aluminium oder einer Aluminiumlegierung nach Anspruch 11 oder 12, **dadurch gekennzeichnet, dass** in einem weiteren Schritt das Graphen dotiert wird, insbesondere mit Ferroniobium, Nickelniobium, Yttrium oder Samariumoxid insbesondere durch Ionenimplantation oder durch Neutronen-Transmutationsdotierung.

15. Verwendung einer Folie nach einem der Ansprüche 1 bis 11 zur Gewinnung von Gleichstrom aus nicht sichtbarer Sonnenenergie.
